# FASCICULE DE BREVET EUROPEEN

(11) **EP 2 766 937 B1**
(45) Date de publication et mention de la délivrance du brevet: **13.04.2016**
(21) Numéro de dépôt: 12788610.9
(22) Date de dépôt: 09.10.2012
(51) Int. Cl.: H01L 35/06, H01L 35/32

(54) **DISPOSITIF THERMOÉLECTRIQUE SÉCURISÉ**
SICHERE THERMOELEKTRISCHE VORRICHTUNG
SECURE THERMOELECTRIC DEVICE

(30) Priorité: 12.10.2011 FR 1103111
(43) Date de publication de la demande: 20.08.2014
(73) Titulaire: Commissariat à l'Énergie Atomique et aux Énergies Alternatives, 75015 Paris (FR)
(72) Inventeur: SAVELLI, Guillaume, F-38000 Grenoble (FR); CORONEL, Philippe, F-38530 Barraux (FR)
(74) Mandataire: Talbot, Alexandre
(86) Numéro de dépôt international: PCT/FR2012/000406
(87) Numéro de publication internationale: WO 2013/054009

(56) Documents cités:
- EP-A1- 0 935 297
- JP-A- 2004 221 409

## Description

### Domaine technique de l'invention

L'invention est relative à un dispositif comportant un module thermoélectrique muni d'un thermocouple qui comporte un premier plot et un second plot en matériaux thermoélectriques différents reliés électriquement par un élément de liaison.

### État de la technique

Les dispositifs thermoélectriques permettent d'exploiter un phénomène physique présent dans certains matériaux. Ce phénomène physique est créé par la relation entre le flux de chaleur qui traverse ces matériaux, et le courant électrique qui les parcourt. Un dispositif thermoélectrique comporte généralement, une pluralité de thermocouples disposés thermiquement en parallèle et reliés électriquement en série par des éléments de connexion métalliques. Chaque thermocouple comporte une paire de plots en matériaux thermoélectriques différents. Les plots d'un thermocouple sont reliés entre eux au niveau de l'une de leurs extrémités par un élément de jonction, formant ainsi une jonction thermoélectrique. Le montage thermique en parallèle peut être réalisé par des côtés chaud et froid disposés de part et d'autre des thermocouples respectivement au niveau des jonctions thermoélectriques et des éléments de connexion des thermocouples, ou inversement.

Un dispositif thermoélectrique peut être utilisé en mode Seebeck ou bien en mode Peltier. En mode Seebeck, également appelé mode générateur de puissance, le dispositif produit une énergie à partir d'un gradient de température entre le côté chaud et le côté froid. En mode Peltier, également appelé mode refroidisseur, l'application d'un courant aux bornes du dispositif thermoélectrique permet de générer un gradient de température entre le côté chaud et le côté froid.

Les dispositifs thermoélectriques en mode refroidisseur sont largement utilisés, notamment pour le refroidissement localisé de composants électroniques. En général, le rendement de ces dispositifs thermoélectriques dépend de plusieurs paramètres, en particulier de l'environnement d'utilisation. Ainsi, suivant des conditions thermiques initiales, l'évolution du refroidissement du dispositif thermoélectrique en fonction du courant injecté possède un optimum : lorsque l'intensité du courant injecté dépasse cet optimum, l'effet Joule prédomine sur l'effet Peltier engendrant ainsi un refroidissement moins efficace allant jusqu'à l'échauffement. Dans certains cas, l'effet du dispositif thermoélectrique sur les composants électroniques peut même s'inverser. Autrement dit, le dispositif thermoélectrique génère un réchauffement au lieu d'un refroidissement, ceci pouvant engendrer une détérioration des composants à refroidir ainsi que du dispositif thermoélectrique.

JP 2004 221409 A divulgue un module thermoélectrique avec un élément de connexion configuré pour se déformer en fonction de sa température.

### Objet de l'invention

Il existe un besoin de prévoir un dispositif muni d'un module thermoélectrique dont la détérioration est limitée.

On tend à satisfaire ce besoin en prévoyant un dispositif comportant un module thermoélectrique muni d'un thermocouple, ledit thermocouple comportant un premier plot et un second plot en matériaux thermoélectriques différents reliés électriquement par un élément de liaison configuré pour se déformer en fonction de sa température de sorte à occuper une première position de déformation dans laquelle les premier et second plots sont reliés électriquement en série uniquement par l'élément de liaison, et une deuxième position de déformation dans laquelle l'élément de liaison est en contact électrique avec un plot de dérivation dudit dispositif. Le plot de dérivation est en un matériau de conductivité électrique supérieure aux conductivités électriques de l'élément de liaison et des premier et second plots. Le dispositif comporte également une charge reliée électriquement au plot de dérivation. Ladite charge a une résistance électrique inférieure à la résistance électrique du module thermoélectrique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 illustrent schématiquement, en coupe, un dispositif selon un premier mode de réalisation de l'invention ;
- la figure 3 illustre schématiquement, une vue de dessus d'un dispositif selon un mode de réalisation de l'invention ; et
- les figures 4 et 5 illustrent schématiquement, en coupe, un dispositif selon un autre mode de réalisation de l'invention.

### Description de modes préférentiels de réalisation

Le dispositif muni d'un module thermoélectrique décrit ci-après diffère de l'art antérieur notamment en ce qu'il prévoit un système de sécurité qui permet d'éviter sa détérioration et/ou la détérioration des dispositifs sensibles à la chaleur se trouvant à son voisinage.

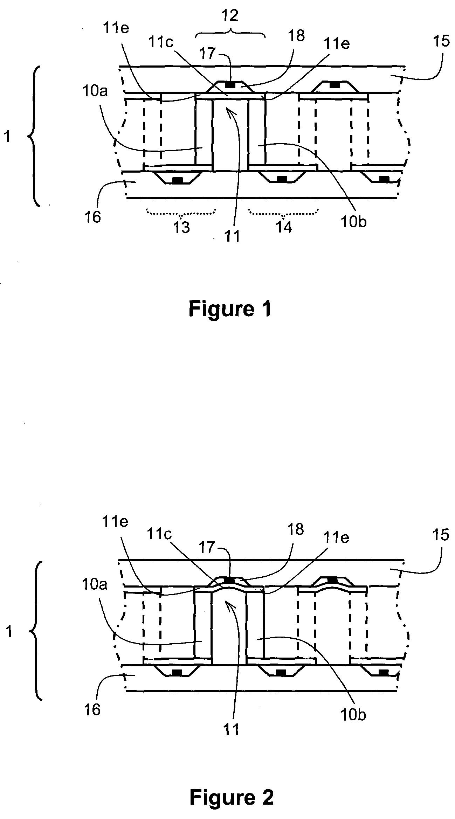

Selon un mode particulier de réalisation illustré aux figures 1 et 2, un dispositif comporte un module thermoélectrique 1 muni d'un thermocouple 12. Le module thermoélectrique 1 comporte un premier plot 10a et un second plot 10b en matériaux thermoélectriques différents. Par matériaux thermoélectriques différents, on entend des matériaux de compositions chimiques différentes, aptes à former un thermocouple, ou bien un même matériau ayant des types de dopage différents.

Les premier et second plots 10a et 10b sont reliés électriquement l'un à l'autre, préférentiellement à l'une de leur extrémité, par un élément de liaison 11. Les premier et second plots 10a et 10b peuvent former le thermocouple 12. L'élément de liaison 11 forme alors l'élément de jonction du thermocouple 12 (la jonction thermoélectrique). Les premier et second plots 10a et 10b peuvent également appartenir à deux thermocouples distincts 13 et 14, reliés électriquement en série. En d'autres termes, l'élément de liaison 11 forme dans ce cas un élément de connexion entre deux thermocouples. Avantageusement, les premier et second plots 10a et 10b sont disposés entre des premier et second supports 15 et 16, formant respectivement un réservoir côté froid à une température T_{c} et un réservoir côté chaud à une température Tₕ supérieure à T_{c}. Les réservoirs côtés froid et chaud 15 et 16 sont disposés de part et d'autre des thermocouples du module thermoélectrique 1, respectivement au niveau des éléments de jonctions thermoélectriques et des éléments de connexion des thermocouples ou inversement.

Les premier et second plots 10a et 10b peuvent être à base de silicium, de tellurure de bismuth, d'alliage de silicium et de germanium, de matériaux siliciurés, des tellures, des oxydes ou tout autre matériau permettant de former un thermocouple. De préférence, les premier et second plots 10a et 10b sont dopés avec des types de dopage différents. Les premier et second supports 15 et 16 peuvent être à base de silicium ou tout autre matériel utilisé comme support pour des dispositifs thermoélectriques usuels.

Comme illustré à la figure 1, l'élément de liaison 11 comporte une zone centrale 11c disposée entre deux extrémités 11e. Les deux extrémités 11e pouvant être interposées respectivement entre les extrémités des premier et second plots 10a et 10b et le premier support 15. La zone centrale 11 c de l'élément de liaison est disposée en regard d'un plot de dérivation 17 du courant électrique circulant dans le module thermoélectrique 1, en particulier entre les premier et second plots 10a et 10b. Le plot de dérivation 17 dudit dispositif est avantageusement, disposé dans le fond d'une cavité 18 formée dans le premier support 15.

L'élément de liaison 11 est avantageusement configuré pour se déformer en fonction de sa température. Selon la température de l'élément de liaison 11, ce dernier peut occuper une première position de déformation suivant laquelle l'élément de liaison 11 est séparé du plot de dérivation 17. Ainsi, les premier et second plots 10a et 10b sont reliés électriquement en série uniquement par l'élément de liaison 11.

Comme illustré à la figure 2, l'élément de liaison 11 est également configuré pour se déformer en fonction de sa température, de manière à pouvoir occuper une deuxième position de déformation dans laquelle il est en contact avec le plot de dérivation 17 dudit dispositif. En fait, sous l'influence d'une variation de sa température, l'élément de liaison 11 subit une déformation structurelle le conduisant à être en contact électrique avec le plot de dérivation 17. Préférentiellement, l'élément de liaison 11 est configuré et disposé de manière à ce que les extrémités 11e restent toujours fixées entre les premier et second plots 10a et 10b et le premier support 15, pour éviter les problèmes de tenue mécanique au niveau des premier et second plots 10a et 10b. De préférence, un matériau d'adhérence, par exemple à base de titane (Ti), peut être interposé entre l'élément de liaison 11 et les premier et second plots 10a et 10b. Le matériau d'adhérence permet ainsi d'améliorer le contact entre l'élément de liaison 11 et les premier et second plots 10a et 10b.

Le plot de dérivation 17 est en un matériau ayant une conductivité électrique supérieure aux conductivités électriques de l'élément de liaison 11 et des premier et second plots 10a et 10b. Le plot de dérivation 17 peut être à base d'un matériau choisi parmi les métaux, les polymères électriquement conducteurs, les oxydes électriquement conducteurs, le graphène ou encore les nanotubes de carbone. Préférentiellement, le plot 17 peut être à base de Cu, Ag, Al, Au, polypyrrole, polyaniline, polyacétylène, sulfure de poly p-phénylène, ZnO, In₂O₃, SnO₂.

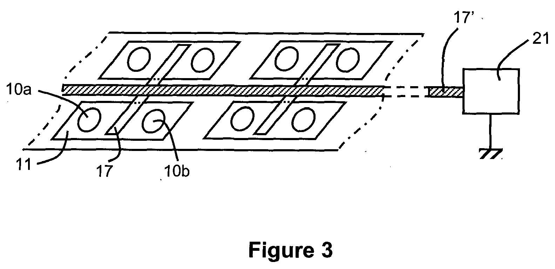

Comme illustré à la figure 3, le plot de dérivation 17 est également relié électriquement à une charge 21 via une piste de connexion 17' destinée à acheminer un courant électrique vers la charge 21. La piste de connexion 17' est préférentiellement à base du même matériau que le plot de dérivation 17. La charge 21 n'appartient pas au module thermoélectrique 1 et a une résistance électrique inférieure à la résistance électrique du module thermoélectrique 1. Ainsi, le contact électrique créé entre l'élément de liaison 11 et le plot de dérivation 17 permet de dévier le courant électrique, circulant habituellement dans le module thermoélectrique 1 vers la charge 21, ce qui permet de désactiver le thermocouple 12 en particulier et le module thermoélectrique 1 en général. Le courant dérivé peut être dissipé dans une résistance. Il peut également alimenter un signal d'alarme sonore ou lumineux, ou encore une boucle de réaction pour arrêter le module thermoélectrique 1.

Ainsi la déformation de l'élément de liaison 11 permet avantageusement, d'arrêter le fonctionnement du module thermoélectrique 1 lorsque la température du côté froid 15, i.e. la température de l'élément de liaison 11, atteint une température critique. Le fait d'arrêter le fonctionnement du module thermoélectrique 1 permet d'éviter une détérioration du module thermoélectrique 1, et des dispositifs sensibles à la chaleur se trouvant à son voisinage.

Avantageusement, l'élément de liaison 11 est réversiblement déformable de manière à basculer de la première position de déformation à la seconde position de déformation lorsque la température de l'élément de liaison 11 devient supérieure à une première température T₁. La déformation réversible de l'élément de liaison 11 engendre également un re-basculement de la deuxième position à la première position de déformation lorsque sa température devient inférieure à une seconde température T₂ inférieure ou égale à la première température T₁.

Les matériaux, les dimensions et la forme géométrique de l'élément de liaison 11 sont choisis de manière à ajuster la température ou les températures pour lesquelles l'élément de liaison 11 bascule de la première à la deuxième position de déformation et inversement. Ainsi, l'élément de liaison 11 peut avantageusement, s'adapter aux différents types d'architectures et de dispositifs thermoélectriques.

L'élément de liaison 11 peut être formé à base d'un alliage à mémoire de forme. Ce type de matériau permet une déformation progressive de l'élément de liaison 11 en fonction de sa température. Un alliage à mémoire de forme est un matériau capable de garder en mémoire une forme initiale et d'y retourner même après une déformation. Ce matériau peut ainsi alterner entre deux formes ou positions de déformation préalablement mémorisées lorsque sa température varie autour d'une température critique.

L'élément de liaison 11 est préférentiellement, un bilame. Par bilame, on entend un empilement d'au moins deux couches ou deux lames en matériaux différents, soudées ou collées l'une contre l'autre. Les matériaux des couches formant le bilame ont des coefficients de dilatation thermique différents. Ainsi, le bilame peut se déformer lorsque sa température varie.

Le bilame formant l'élément de liaison 11, peut être réalisé en utilisant les techniques de microfabrication en salle blanche. Ce type de bilame est généralement utilisé dans des structures ayant des épaisseurs micrométriques, allant de quelques micromètres à quelques millimètres. Les bilames réalisés suivant ces techniques comportent avantageusement une couche en silicium (Si) ou en oxyde de silicium (SiO₂). Le matériau d'une couche additionnelle du bilame est choisi de manière à être compatible avec les techniques de microfabrication, à être un bon conducteur électrique, et à avoir un écart de coefficient de dilatation thermique, par rapport à celui de la couche en Si ou bien en SiO₂, le plus grand possible. Préférentiellement, la couche additionnelle du bilame est en aluminium (Al), en or (Au) ou encore en plomb (Pb). Ce sont des matériaux largement utilisés en salle blanche et ayant un coefficient de dilatation thermique qui peut être associé à une couche en Si ou en SiO₂. Il est donc avantageux que l'élément de liaison 11 comporte une couche en silicium ou bien en oxyde de silicium et une couche en un matériau choisi parmi Al, Au et Pb.

Pour des bilames à l'échelle macroscopique, ayant une épaisseur pouvant dépasser quelques millimètres, les différentes couches comprises dans le bilame sont, préférentiellement, soudées à froid. Ce type de bilame comporte avantageusement une couche en Invar, un matériau correspondant à un alliage de fer (Fe) et de nickel (Ni) avec différentes compositions. L'invar est un alliage métallique ayant un coefficient de dilatation thermique faible, de l'ordre de 0,5.10⁻⁶ K⁻¹. Il est également avantageux que le bilame comporte une couche permettant d'avoir un écart important entre les coefficients de dilatation thermique des couches du bilame. En effet, la déformation est proportionnelle à l'écart entre les coefficients de dilatation thermique des matériaux des couches d'un bilame, ainsi plus cet écart est important plus la déformation du bilame est importante. Préférentiellement, le bilame comporte une couche additionnelle en alliages tels que fer-nickel-chrome, fer-nickel-cobalt ou encore fer-nickel-manganèse. À titre d'exemple, les coefficients de dilatation thermique des alliages Fe-Ni-Cr et Fe-Ni-Mn sont respectivement de l'ordre de 17,4.10⁻⁶ K⁻¹ et 18,4.10⁻⁶ K⁻¹, largement supérieurs au coefficient de dilatation thermique de l'Invar.

Selon une mise en oeuvre particulière, le module thermoélectrique 1 du dispositif comporte de préférence, une pluralité de thermocouples 12 reliés électriquement en série et comportant chacun des premier et second plots 10a et 10b en matériaux thermoélectriques différents reliées électriquement par un élément de liaison 11.

Dans une première variante, l'élément de liaison 11 peut être intégré dans un dispositif, selon l'invention, muni d'un module thermoélectrique 1 configuré en mode refroidisseur. Sous certaines conditions d'utilisation, le fonctionnement du module thermoélectrique 1 peut être altéré de manière à réchauffer son environnement au lieu de le refroidir. Ainsi, la température de l'élément de liaison 11 augmente jusqu'à ce qu'il occupe la deuxième position de déformation. Cette position de déformation permet avantageusement, l'arrêt du fonctionnement du module thermoélectrique 1, évitant ainsi le réchauffement de son environnement et la détérioration du module thermoélectrique 1.

Dans une seconde variante, l'élément de liaison 11 peut également être intégré dans un dispositif, selon l'invention, muni d'un module thermoélectrique 1 configuré en mode générateur de puissance. Suivant cette configuration, le module thermoélectrique 1 génère un courant électrique circulant à travers les premier et second plots 10a et 10b. Cette circulation du courant électrique peut engendrer une augmentation de la température du module par effet Joule. L'augmentation de la température du module peut être accentuée si la température du côté froid 15 ou du côté chaud 16 est importante, produisant ainsi une détérioration du module thermoélectrique 1. Il est alors avantageux d'utiliser un élément de liaison 11 tel que décrit ci-dessus afin de suspendre le fonctionnement du module thermoélectrique 1 lorsque sa température atteint une température critique.

Dans le cas où le module thermoélectrique 1 comporte une pluralité de thermocouples 12 reliés en série, l'arrêt de fonctionnement du module thermoélectrique 1 peut être effectué par un seul élément de liaison 11 dans la série en créant une dérivation du courant électrique vers la charge 21. Cependant, les thermocouples du module thermoélectrique 1 se trouvant en amont ou en aval de l'élément de liaison 11, selon l'invention, peuvent encore faire circuler un courant électrique créé par un effet Seebeck parasite, généré par le gradient de température entre le côté froid 15 et le côté chaud 16. Ce courant électrique peut à lui seul détériorer les thermocouples 12 se trouvant en amont ou en aval de l'élément de liaison 11, selon l'invention, et générer un réchauffement indésirable par effet Joule.

Pour pallier ces phénomènes indésirables, il est avantageux d'utiliser des éléments de liaison tels que décrit ci-dessus au lieu de tous les éléments de jonction et de tous les éléments de connexion du module thermoélectrique 1. Autrement dit, chaque thermocouple 12 est associé à un plot de dérivation 17 et chaque élément de liaison 11 du module thermoélectrique 1 est configuré pour se déformer en fonction de sa température de sorte à occuper une des première et seconde positions de déformation. Dans la première position de déformation, les premier et second plots d'une même paire (10a, 10b) sont reliés électriquement en série uniquement par l'élément de liaison 11. Dans la seconde position de déformation, l'élément de liaison 11 est en contact électrique avec un plot de dérivation 17 en un matériau de conductivité électrique supérieure aux conductivités électriques de l'élément de liaison 11 et des premier et second plots de la même paire (10a, 10b). Chaque plot de dérivation 17 du module thermoélectrique 1 est électriquement relié, à une charge 21 ayant une résistance électrique inférieure à la résistance électrique du module thermoélectrique 1.

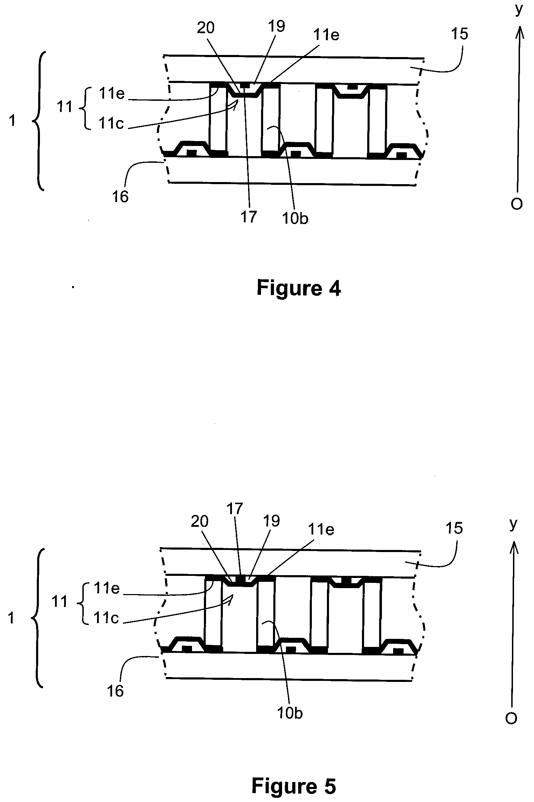

Selon un second mode de réalisation illustré aux figures 4 et 5, l'élément de liaison entre les plots en matériaux thermoélectriques différents est un bilame de type cloquant. Le module thermoélectrique 1 comporte des éléments semblables à ceux illustrés aux figures 1 et 2 et désignés par des mêmes références. On retrouve notamment des premier et second plots 10a et 10b, disposés entre deux supports 15 et 16. Les deux supports 15 et 16 sont associés respectivement à un côté chaud et un côté froid, ou inversement. Suivant ce mode de réalisation, les supports 15 et 16 peuvent être dépourvus des cavités 18. On retrouve alors des plots de dérivation 17 disposés sur les surfaces en regard des supports 15 et 16. Les premier et second plots 10a et 10b sont reliés entre eux à l'une de leur extrémité par un élément de liaison 11, qui est un bilame de type cloquant.

Par bilame de type cloquant, on entend un bilame dans lequel la commutation entre deux positions de déformation, en fonction de sa température, s'effectue par déflexion d'une courbure « cloquante » élastique. En fonction de sa température, l'élément de liaison 11 « cloque » et vient au contact du plot de dérivation 17. Par « cloquer » on entend que la courbure d'une forme concave selon une direction prédéterminée, subit une déflexion de manière à ce que la courbure devienne convexe selon ladite direction.

Les matériaux, les dimensions et la forme géométrique du bilame cloquant sont choisis de sorte à fixer la ou les températures de basculement de la première position de déformation à la deuxième position de déformation et inversement. Un bilame cloquant est généralement réalisé par un pressage destiné à former la courbure. La forme de cette courbure, ainsi que la force de pressage permettent notamment d'ajuster les températures de basculement du bilame cloquant. Ce type de bilame permet avantageusement de relâcher les contraintes sur le choix des matériaux et des dimensions du bilame. De ce fait, selon l'architecture et le type du module thermoélectrique 1, l'élément de liaison 11 peut être intégré et adapté en ajustant les caractéristiques de la courbure du bilame cloquant.

Comme illustré à la figure 4, l'élément de liaison 11 comporte une courbure concave selon l'axe (oy) formant une cavité 19 munie d'un fond 20. L'espace délimité entre la cavité 19 et le support 15 comporte le plot de dérivation 17. Le fond 20 de la cavité 19 est séparé du plot de dérivation 17, définissant ainsi une première position de déformation dans laquelle les premier et second plots 10a et 10b sont reliés électriquement en série uniquement par l'élément de liaison 11.

Comme illustré à la figure 5, en fonction de sa température, l'élément de liaison 11 bascule de la première position de déformation à une seconde position de déformation dans laquelle le fond 20 est en contact avec le plot de dérivation 17. Le plot de dérivation 17 est en un matériau ayant une conductivité électrique supérieure aux conductivités électriques de l'élément de liaison 11 et des premier et second plots 10a et 10b. Le plot de dérivation 17 est également relié électriquement à une charge 21 (non représentée sur les figures 4 et 5) via une piste de connexion 17' destinée à acheminer un courant électrique vers la charge 21. La piste de connexion 17' est préférentiellement à base du même matériau que le plot de dérivation 17. La charge 21 a une résistance électrique inférieure à la résistance électrique du module thermoélectrique 1. Ainsi, le contact électrique créé entre l'élément de liaison 11 et le plot de dérivation 17 permet de dévier le courant électrique vers la charge 21, ce qui permet de désactiver le thermocouple 12 en particulier et le module thermoélectrique 1 en général.

Comme illustré à la figure 5, le plot de dérivation 17 est disposé de manière à ce qu'il arrête la course de l'élément de liaison 11 au cours de son « cloquage », permettant ainsi d'établir un contact électrique entre l'élément de liaison 11 et le plot de dérivation 17 et la déviation du courant électrique circulant habituellement entre les premier et second plots 10a et 10b via l'élément de liaison 11.

Préférentiellement, l'élément de liaison 11 comporte une zone centrale 11c disposée entre deux extrémités 11e interposées entre les extrémités des premier et second plots 10a et 10b et le support 15. La zone centrale 11c de l'élément de liaison 11 a la forme d'une courbure concave selon l'axe (oy) de manière à former la cavité 19. L'élément de liaison 11 est, de préférence, configuré et disposé de manière à ce que les extrémités 11e reste toujours fixées entre les premier et second plots 10a et 10b et le support 15. Uniquement la partie centrale 11 c cloque, ce qui permet d'éviter les problèmes de tenues mécaniques au niveau des premier et second plots 10a et 10b.

Le contact entre l'élément de liaison 11 et le plot de dérivation 17 peut également être effectué après le « cloquage » total de l'élément de liaison 11. Autrement dit, la cavité 19 se retourne de manière à ce que l'élément de liaison 11 soit en contact avec le plot de dérivation 17. On entend par retournement de la cavité 19, le fait que la courbure formant la cavité 19 se transforme d'une courbure concave en une courbure convexe selon l'axe (oy), ou inversement.

## Revendications

1. Dispositif comportant un module thermoélectrique (1) muni d'un thermocouple (12), ledit thermocouple (12) comportant un premier plot (10a) et un second plot (10b) en matériaux thermoélectriques différents reliés électriquement par un élément de liaison (11),
**caractérisé en ce que** l'élément de liaison (11) est configuré pour se déformer en fonction de sa température de sorte à occuper :
- une première position de déformation dans laquelle les premier et second plots (10a, 10b) sont reliés électriquement en série uniquement par l'élément de liaison (11) ;
- une deuxième position de déformation dans laquelle l'élément de liaison (11) est en contact électrique avec un plot de dérivation (17) dudit dispositif, ledit plot de dérivation (17) étant en un matériau de conductivité électrique supérieure aux conductivités électriques de l'élément de liaison (11) et des premier et second plots (10a, 10b) ;
et **en ce que** le dispositif comporte une charge (21) ayant une résistance électrique inférieure à la résistance électrique du module thermoélectrique (1), ladite charge (21) étant reliée électriquement au plot de dérivation (17).

2. Dispositif selon la revendication 1, **caractérisé en ce que** le plot de dérivation (17) est en un matériau choisi parmi les métaux, les polymères électriquement conducteurs, les oxydes électriquement conducteurs, le graphène et les nanotubes de carbone.

3. Dispositif selon l'une des revendications 1 et 2, **caractérisé en ce que** l'élément de liaison (11) est réversiblement déformable de manière à basculer de la première position à la deuxième position de déformation lorsque sa température devient supérieure à une première température T₁, et à rebasculer de la deuxième position à la première position de déformation lorsque sa température devient inférieure à une seconde température T₂ inférieure ou égale à la première température T₁.

4. Dispositif selon l'une quelconque des revendications 1 à 3, **caractérisé en ce que** l'élément de liaison (11) est un bilame.

5. Dispositif selon la revendications 4, **caractérisé en ce que** l'élément de liaison (11) comporte un alliage de Fe et de Ni.

6. Dispositif selon l'une des revendications 4 et 5, **caractérisé en ce que** l'élément de liaison (11) comporte un alliage de Fe, de Ni et d'un élément choisi parmi Cr, Co ou Mn.

7. Dispositif selon la revendication 4, **caractérisé en ce que** l'élément de liaison (11) comporte une couche en silicium ou en oxyde de silicium.

8. Dispositif selon la revendication 7, **caractérisé en ce que** l'élément de liaison (11) comporte une couche en un matériau choisi parmi Al, Au, Pb.

9. Dispositif selon l'une des revendications 4 à 6, **caractérisé en ce que** le bilame est de type cloquant.

10. Dispositif selon la revendication 9, **caractérisé en ce que** l'élément de liaison (11) comporte une cavité (19) ayant un fond (20) séparé du plot de dérivation (17) lorsque l'élément de liaison occupe la première position de déformation, le fond (20) étant en contact avec le plot de dérivation (17) lorsque l'élément de liaison (11) est en seconde position de déformation.

11. Dispositif selon la revendication 9, **caractérisé en ce que** l'élément de liaison (11) comporte une cavité (19), et **en ce que** la cavité (19) se retourne de manière à ce que l'élément de liaison (11) soit en contact avec le plot de dérivation (17).

12. Dispositif selon la revendication 1, **caractérisé en ce que** l'élément de liaison (11) est à base d'un alliage à mémoire de forme.

13. Dispositif selon la revendication 1, **caractérisé en ce que** :
- le module thermoélectrique comporte une pluralité de thermocouples (12) reliés électriquement en série et comportant chacun des premier et second plot (10a) et (10b) en matériaux thermoélectriques différents reliés électriquement par un élément de liaison (11) ;
- chaque thermocouple (12) est associé à un plot de dérivation (17) ;
- chaque élément de liaison (11) est configuré pour se déformer en fonction de sa température de sorte à occuper une des première et seconde positions de déformation ; et
- chaque plot de dérivation (17) est relié à la charge (21).

## Patentansprüche

1. Vorrichtung mit einem thermoelektrischen Modul (1), das mit einem Thermoelement (12) versehen ist, wobei das Thermoelement (12) einen ersten Stift (10a) und einen zweiten Stift (10b) aus unterschiedlichen thermoelektrischen Materialien aufweist, die über ein Verbindungselement (11) elektrisch verbunden sind, dadurch gekenntzeichnet, dass das Verbindungselement (11) derart ausgeführt ist, dass es sich in Abhängigkeit seiner Temperatur verformt, um:
- eine erste Verformungsposition einzunehmen, in der der erste und zweite Stift (10a, 10b) elektrisch nur über das Verbindungselement (11) in Serie verbunden sind;
- eine zweite Verformungsposition anzunehmen, in der das Verbindungselement (11) in elektrischem Kontakt mit einem Abzweigstift (17) der Vorrichtung steht, wobei der Abzweigstift (17) aus einem Material mit einer elektrischen Leitfähigkeit besteht, die höher als die elektrische Leitfähigkeit des Verbindungselements (11) und des ersten und zweiten Stiftes (10a, 10b) ist;
und dass die Vorrichtung eine Last (21) umfasst, welche einen elektrischen Widerstand aufweist, der geringer als der elektrische Widerstand des thermoelektrischen Moduls (1) ist, wobei diese Last (21) elektrisch mit dem Abzweigstift (17) verbunden ist.

2. Vorrichtung gemäß Anspruch 1, **dadurch gekennzeichnet, dass** der Abzweigstift (17) aus einem Material besteht, das aus Metallen, elektrisch leitenden Polymeren, elektrisch leitenden Oxiden, Graphen und Kohlenstoffnanoröhren ausgewählt ist.

3. Vorrichtung gemäß einem der Ansprüche 1 und 2, **dadurch gekennzeichnet, dass** das Verbindungselement (11) derart reversibel verformbar ist, dass es von der ersten Stellung in die zweite Verformungsstellung schwenkt, wenn seine Temperatur über eine erste Temperatur T₁ steigt, und von der zweiten Stellung in die erste Verformungsstellung zurückschwenkt, wenn seine Temperatur unter eine zweite Temperatur T₂ fällt, die geringer als die oder gleich der ersten Temperatur T₁ ist.

4. Vorrichtung gemäß einem der Ansprüche 1 bis 3, **dadurch gekennzeichnet, dass** das Verbindungselement (11) ein Bimetall ist.

5. Vorrichtung gemäß Anspruch 4, **dadurch gekennzeichnet, dass** das Verbindungselement (11) eine Legierung aus Fe und Ni umfasst.

6. Vorrichtung gemäß einem der Ansprüche 4 und 5, **dadurch gekennzeichnet, dass** das Verbindungselement (11) eine Legierung aus Fe, aus Ni und aus einem Element ausgewählt aus Cr, Co oder Mn umfasst.

7. Vorrichtung gemäß Anspruch 4, **dadurch gekennzeichnet, dass** das Verbindungselement (11) eine Schicht aus Silizium oder aus Siliziumoxid umfaßt.

8. Vorrichtung gemäß Anspruch 7, dadurch gekennzeichet dass das Verbindungselement (11) eine Schicht aus einem Material ausgewählt aus Al, Au, Pb umufasst.

9. Vorrichtung gemäß einem der Ansprüche 4 bis 6, dadurch gekennzeichet, dass sich das Bimetall ausbaucht.

10. Vorrichtung gemäß Anspruch 9, **dadurch gekennzeichnet, dass** das Verbindungselement (11) einen Hohlraum (19) mit einem Boden (20) aufweist, der von dem Abzweigstift (17) getrennt ist, wenn das Verbindungselement die erste Verformmungsstellung einnimmt, wobei der Boden (20) mit dem Abzweigstift (17) in Kontakt steht, wenn sich das Verbindungselement (11) in der zweiten Verformungsstellung befindet.

11. Vorrichtung gemäß Anspruch 9, **dadurch gekennzeichnet, dass** das Verbindungselement (11) einen Hohlraum (19) aufweist und dass der Hohlraum (19) sich derart umdreht, dass das Verbindungselement (11) mit dem Abzweigstift (17) in Kontakt steht.

12. Vorrichtung gemäß Anspruch 1, **dadurch gekennzeichnet, dass** das Verbindungselement (11) auf einer Formgedächtnislegierung beruht.

13. Vorrichtung gemäß Anspruch 1, **dadurch gekennzeichnet, dass**:
- das thermoelektrische Modul mehrere Thermoelemente (12) umfasst, die elektrisch in Serie verbunden sind und jeweils einen ersten und zweiten Stift (10a) und (10b) aus unterschiedlichen thermoelektrischen Materialien aufweisen, welche elektrisch über ein Verbindungselement (11) verbunden sind;
- jedes Thermoelement (12) mit einem Abzweigstift (17) verknüpft ist;
- jedes Verbindungselement (11) so ausgeführt ist, dass es sich in Abhängigkeit seiner Temperatur verformt, um eine der ersten und zweiten Verformungsstellungen einzunehmen; und
- jeder Abzweigstift (17) mit der Last (21) verbunden ist.

## Claims

1. A device comprising a thermoelectric module (1) provided with a thermo-couple (12), said thermocouple (12) comprising a first leg (10a) and a second leg (10b) made of different thermoelectric materials electrically connected by a connecting element (11),
**characterized in that** the connecting element (11) is configured to deform according to its temperature so as to assume:
• a first deformation position where the first and second legs (10a, 10b) are electrically series-connected solely by the connecting element (11);
• a second deformation position where the connecting element (11) is in electric contact with a shunt contact pad (17) of said device, said shunt contact pad (17) being made of a material having a greater electric conductivity than the connecting element (11) and the first and second legs (10a, 10b);
and **in that** the device comprises a load (21) having a smaller electric resistance than the thermoelectric module (1), said load (21) being electrically connected to the shunt contact pad (17).

2. The device according to claim 1, **characterized in that** the shunt contact pad (17) is made of a material selected from among metals, electrically-conductive polymers, electrically-conductive oxides, graphene, and carbon nanotubes.

3. The device according to any of claims 1 and 2, **characterized in that** the connecting element (11) is reversibly deformable to switch from the first position to the second deformation position when its temperature becomes greater than a first temperature T₁, and to switch back from the second position to the first deformation position when its temperature becomes lower than a second temperature T₂ smaller than or equal to first temperature T₁.

4. The device according to any of claims 1 to 3, **characterized in that** the connecting element (11) is a bistrip.

5. The device according to claim 4, **characterized in that** the connecting element (11) comprises an alloy of Fe and Ni.

6. The device according to any of claims 4 and 5, **characterized in that** the connecting element (11) comprises an alloy of Fe, of Ni, and of an element selected from among Cr, Co, or Mn.

7. The device according to claim 4, **characterized in that** the connecting element (11) comprises a silicon or silicon oxide layer.

8. The device according to claim 7, **characterized in that** the connecting element (11) comprises a layer of a material selected from among Al, Au, Pb.

9. The device according to any of claims 4 to 6, **characterized in that** the bistrip is of blistering type.

10. The device according to claim 9, **characterized in that** the connecting element (11) comprises a cavity (19) having a bottom (20) separated from the shunt contact pad (17) when the connecting element assumes the first deformation position, the bottom (20) being in contact with the shunt contact pad (17) when the connecting element (11) is in the second deformation position.

11. The device according to claim 9, **characterized in that** the connecting element (11) comprises a cavity (19), and **in that** the cavity (19) reverses so that the connecting element (11) is in contact with the shunt contact pad (17).

12. The device according to claim 1, **characterized in that** the connecting element (11) is based on a shape-memory alloy.

13. The device according to claim 1, **characterized in that**:
• the thermoelectric module comprises a plurality of thermocouples (12) electrically series-connected and each comprising first and second legs (10a) and (10b) made of different thermoelectric materials electrically connected by a connecting element (11);
• each thermocouple (12) is associated with a shunt contact pad (17);
• each connecting element (11) is configured to deform according to its temperature to assume one of the first and second deformation positions; and
• each shunt contact pad (17) is connected to the load (21).
